# EUROPÄISCHE PATENTANMELDUNG

(11) **EP 2 631 659 A2**
(43) Veröffentlichungstag der Anmeldung: **28.08.2013**
(21) Anmeldenummer: 13156661.4
(22) Anmeldetag: 26.02.2013
(51) Int. Cl.: G01R 1/04

(54) **Kontaktierungsanordnung zur elektrischen Kontaktierung von Testpunkten**

(30) Priorität: 27.02.2012 DE 102012101556
(71) Anmelder: Göpel electronic GmbH, 07745 Jena (DE)
(72) Erfinder: Borowski, Martin, 07743 Jena (DE); Richter, Romin, 07743 Jena (DE); Steinhäuser, Tim, 99423 Weimar (DE)
(74) Vertreter: Oehmke, Volker

(57) **Zusammenfassung**

Die Erfindung betrifft eine Kontaktierungsanordnung zur elektrischen Kontaktierung einer Anzahl von Testpunkten (14a bis 14k) auf einer Leiterplatte (10) und einen Adapter (1) zur Kontaktierung der Testpunkte (14a bis 14k). Es wird eine universal anwendbare Möglichkeit vorgeschlagen, um insbesondere automatisch JTAG-Schnittstellen zur Durchführung von Tests, wie den Boundary-Scan-Test oder die JTAG-Emulation, zu adaptieren. Die erfindungsgemäße Kontaktierungsanordnung ist dadurch gekennzeichnet, dass mindestens ein Durchbruch (12) in der Leiterplatte (10) zur gerichteten Aufnahme des Adapters (6) vorhanden ist, zwei der Testpunkte (14a bis 14k) miteinander elektrisch kurzgeschlossen sind, um eine Detektion relativer Lagen des Adapters (1) zu der Leiterplatte (10) zu ermöglichen und der Adapter (1) ein Führungsmittel (6) aufweist und das Führungsmittel (6) in den Durchbruch (12) so einsteckbar ist, dass bei vollständig eingestecktem Adapter (1) die Nadelspitzen mit den Testpunkten (14a bis 14k) elektrisch kontaktiert sind.

## Beschreibung

Die Erfindung betrifft eine Kontaktierungsanordnung zur elektrischen Kontaktierung von auf einer Leiterplatte befindlichen Testpunkten, wie dies gattungsgemäß aus der DD 215 867 A1 bekannt ist.

Seit es Leiterplatten gibt, besteht die Notwendigkeit, deren elektrische Funktionsfähigkeit zu testen. Bekannte Testverfahren sind der In-Circuit-Test und der Flying-Probe-Test, die sich dadurch auszeichnen, dass die elektrische Kontaktierung einzelner Leiterbahnen über Kontaktnadeln (fortan kurz: Nadeln) erfolgt. Beim In-Circuit Test erfolgt dies in einem Nadelbettadapter (fortan: Adapter), wobei die einzelnen Nadeln starr angeordnet sind und nur in horizontaler Richtung verändert werden können. Ein derartiger Adapter wird in der DD 254 788 A1 vorgestellt. Mit der DE 198 47 146 A1 wird ebenfalls ein Adapter offenbart, wobei die Schrift sich insbesondere mit der Verbesserung der Toleranzen befasst, wie sie bei der Kontaktierung von Testpunkten mit solch einem Adapter immer auftreten. Hierzu wird die Verwendung einer Einstelleinrichtung vorgeschlagen, mittels derer die Position der Leiterplatte in Bezug auf die Nadeln einstellbar wird. Ein weiterer Adapter wird in der DD 254 789 A1 vorgestellt, der zum Höhenausgleich der Nadeln oberhalb dieser die Anordnung einer elastischen Platte vorsieht. Die Information über die Positionierung der einzelnen Nadeln soll jeweils aus dem Layout der zu prüfenden Leiterplatte gewonnen werden.

Durch die DD 215 867 A1 ist ein Adapter bekannt, bei dem in einem Gehäuse eine Anzahl von Nadeln vorhanden ist, die in einer Zwischenplatte straff geführt sind. Die Nadeln ragen durch Führungslöcher einer Grundplatte, wodurch über der Grundplatte durch die Anordnung der Nadeln ein Nadelraster gebildet ist, das ein bestimmtes Muster aufweist. Das Muster entspricht in Form und Dimension einem weiteren Muster, welches durch die zu kontaktierenden Testpunkte auf der Leiterplatte gebildet ist. Die Nadeln sind mit einer Mess- und Prüfanordnung verbunden. In dem Gehäuse ist eine seitlich abgeflachte Walze vorhanden, die bei ihrer Drehung mit den Nadeln in Berührung kommt und diese lateral biegt. Durch die Biegung werden die als spitze Kontaktköpfe ausgebildeten Nadelspitzen aus ihrer ursprünglichen Position (fortan: Ruheposition) in eine laterale Position verschoben, wodurch über die Nadeln eine Klemmung des Adapters in als Testpunkte fungierenden Lötaugen der Leiterplatte erreichbar ist. Ein Adapter gemäß der Offenbarung der DD 215 867 A1 erfordert eine sehr präzise Anordnung der Nadeln in dem Muster und erlaubt einen individuellen Ausgleich von Abweichungen höchstens in dem geringen Maße, in dem die Nadeln in den Führungslöchern lateral beweglich sind. Die Verschiebung der Nadelspitzen in eine laterale Position ist nur für alle Nadeln gleichzeitig und nicht individuell möglich.

In der US 2005/0083071 A1 ist eine Möglichkeit zur Kontaktierung von Testpunkten beschrieben, bei der zur elektrischen Kontaktierung dienende Nadeln in einer schwimmend gelagerten Basis angeordnet sind, die lateral, also in einer Ebene parallel zur Ebene der Testpunkte um einen bestimmten Maximalbetrag beweglich ist. Um eventuelle Ungleichmäßigkeiten der Ebene der Testpunkte auszugleichen und um eine Beschädigung der Nadeln zu vermeiden, kann die Basis zudem federnd gelagert sein. An und / oder neben der Basis sind Führungselemente vorhanden, die in Durchbrüche der zu kontaktierenden Leiterplatte einsteckbar sind. Durch diese einsteckbaren Führungselemente ist eine grobe Justierung von Basis und Leiterplatte zueinander ermöglicht. Eine feinere Justierung ist durch die lateral bewegliche Basis möglich. Allerdings können mittels dieser Ausführung nur alle Nadeln zugleich in eine gemeinsame laterale Richtung justiert werden. Eine individuelle Anpassung ist auch hier nicht möglich.

Beim Flying-Probe-Test sind die einzelnen Nadeln in alle Richtungen beweglich angeordnet. Beide Testverfahren sind sehr aufwendig und können deshalb erst ab einer bestimmten Stückzahl an zu testenden Leiterplatten oder erst ab einer gewissen Zahl von Testpunkten wirtschaftlich betrieben werden.

Bekannt ist die elektrische Prüfung von Leiterplatten nach dem Standard IEEE 1149.1. Besondere Bedeutung hat dabei die sogenannte Grenzpfadabtastung (Boundary-Scan-Test) erlangt, die es erlaubt, ausgehend von einer JTAG-(Joint Test Action Group) Schnittstelle, mit lediglich fünf Signalen (Testbusse) und einer Spannungsversorgung eine elektrische Prüfung einer elektronischen Einheit wie einer Leiterplatte durchzuführen. Über eine JTAG-Schnittstelle ist auch ein JTAG-Emulation-Test durchführbar.

Bislang existiert jedoch kein einheitlicher Standard für eine Adaptierung von JTAG-Schnittstellen, so dass die Adaptierung von verschiedenen Herstellern unterschiedlich gelöst ist. Werden neben den elektrischen Prüfungen auch automatische optische Prüfungen (automatic optical inspection, AOI) vorgenommen, stellen sich besondere Anforderungen an die Einhaltung von Toleranzen der Lage der Testpunkte. Im Gegensatz zu einem typischen In-Circuit-Test, bei dem eine Leiterplatte fixiert ist und Abweichungen von 0,1 mm außerhalb der zulässigen Toleranz liegen, können solche Toleranzen bei einer AOI durch die Aufnahme und Auswertung von Passermarken ausgeglichen werden.

Um Tests sowohl auf der Basis von Kontaktierungen mittels Nadeln als auch AOI's effizient in Produktionslinien einsetzen zu können, sind automatische Adaptierungen mittels Nadeln erwünscht, die auch bei Abweichungen der Lage der Testpunkte mit größeren Toleranzen sicher arbeiten.

Der Erfindung liegt die Aufgabe zugrunde, eine Möglichkeit zur Kontaktierung von Testpunkten einer elektrischen oder elektronischen Einheit wie einer Leiterplatte mittels Nadeln vorzuschlagen, mittels der größere Abweichungen der Lage der Testpunkte ausgleichbar sind.

Die Aufgabe wird durch eine Kontaktierungsanordnung zur elektrischen Kontaktierung einer Anzahl von Testpunkten auf einer Leiterplatte gelöst. Die Kontaktierungsanordnung weist die Leiterplatte mit den Testpunkten und einen Adapter auf. Die Testpunkte sind auf der Leiterplatte in einem spiegelsymmetrischen Muster angeordnet. In der Leiterplatte ist mindestens ein Durchbruch vorhanden. Zwei der Testpunkte sind miteinander elektrisch kurzgeschlossen. Der Adapter dient zur Kontaktierung der Testpunkte und weist ein Führungsmittel und Nadeln mit Nadelspitzen auf. Das Führungsmittel ist in den mindestens einen Durchbruch der Leiterplatte einsteckbar. Bei vollständig in den mindestens einen Durchbruch eingestecktem Führungsmittel steht jede der Nadelspitzen mit genau einem Testpunkt in Verbindung. Vorzugsweise ist diese Verbindung elektrisch leitend. Jede einzelne Nadel weist eine Längsachse auf und ist lateral zu ihrer Längsachse taumelnd gelagert.

Der verwendete Begriff einer Leiterplatte bezieht sich allgemein auf eine Basis, auf der die Testpunkte vorhanden sind und schließt auch andere elektrische und elektronische Einheiten ein, die mittels der erfindungsgemäßen Kontaktierungsanordnung prüfbar sind. Unter größeren Abweichungen der Lage der Testpunkte sind vorzugsweise Abweichungen bis 1,5 mm zu verstehen. Einem Einstecken des Führungsmittels in den Durchbruch bzw. in die Durchbrüche steht ein Durchstecken durch den Durchbruch bzw. durch die Durchbrüche gleich.

Das spiegelsymmetrische Muster der Testpunkte (fortan kurz: Muster) und das spiegelsymmetrische Muster der Nadelspitzen wird dann als gleich angesehen, wenn diese komplementär zueinander sind. Dies ist gegeben, wenn bei eingestecktem Führungsmittel in den mindestens einen Durchbruch jedem Testpunkt eine Nadelspitze zugeordnet ist und jeweils eine elektrisch leitende Kontaktierung zwischen beiden ermöglicht ist.

In einer bevorzugten Ausführung der erfindungsgemäßen Kontaktierungs-anordnung weist der mindestens eine Durchbruch in der Leiterplatte mindestens eine Symmetrieachse (Symmetrieachse des Durchbruchs) auf. Eine Symmetrieachse des Musters fällt mit der Symmetrieachse des Durchbruchs zusammen.

Zudem ist es günstig, wenn eine Symmetrieachse des Musters der Nadelspitzenmit der Symmetrieachse des Durchbruchs zusammenfällt. Sind mehrere Durchbrüche vorhanden, so gilt Vorstehendes entsprechend.

Ein Zusammenfallen der Symmetrieachsen der Muster der Testpunkte und der Nadelspitzen sowie der Symmetrieachse des Durchbruchs erlaubt vorteilhaft ein Kontaktieren der Leiterplatte durch den erfindungsgemäßen Adapter von beiden Seiten der Leiterplatte her.

Ist nur ein einzelner Durchbruch vorhanden, so ist es bevorzugt, wenn dieser einen von einer kreisrunden Form abweichenden und bezüglich der Symmetrieachse des Musters spiegelsymmetrischen Querschnitt aufweist.

Sehr günstig ist es, wenn der Durchbruch oder die Durchbrüche so gestaltet und angeordnet sind, dass der Adapter von einer der Seitenflächen der Leiterplatte her nur in einer einzigen erlaubten Ausrichtung einsteckbar ist. Das kann durch unterschiedlich dimensionierte Durchbrüche erreicht sein. So können die Durchbrüche in einem einfachen Fall unterschiedlich große Durchmesser aufweisen. Auch können die Durchbrüche voneinander verschiedene Formen aufweisen.

Ein Durchbruch kann beispielsweise einen eier- oder T-förmigen Querschnitt aufweisen. Auch könnte der Durchbruch beispielsweise die Form einer liegenden Acht aufweisen, wobei die Bögen der Acht vorzugsweise verschieden groß sind.

Durch eine spiegelsymmetrische Anordnung der Testpunkte und Durchbrüche, beziehungsweise der spiegelsymmetrischen Gestaltung eines einzelnen Durchbruchs ist es möglich, die Testpunkte von beiden Seitenflächen der Leiterplatte her zu kontaktieren.

Die Nadeln sind vorzugsweise in einem Gehäuse angeordnet und gelagert. Ein Gehäuse kann ein von Wänden umgrenzter Raum oder eine zur Aufnahme und Lagerung der Nadeln geeignete Struktur wie ein Gerüst oder ein Käfig sein.

Durch die taumelnde Lagerung der Nadeln ist eine laterale Beweglichkeit jeder der Nadeln ermöglicht. Unter einer lateralen Beweglichkeit wird verstanden, dass die Längsachse einer jeden Nadel aus einer Ausgangslage in eine Arbeitslage überführt ist. Die Längsachse einer Nadel nimmt in einem ersten Arbeitszustand des erfindungsgemäßen Adapters eine vorbestimmte erste räumliche Lage ein, die als Ausgangslage bezeichnet wird. Die Ausgangslage ist beispielweise bei Nadeln eines Adapters gegeben, der nicht mit seinem Führungsmittel in einen Durchbruch einer Leiterplatte eingesteckt ist und dessen Nadeln auch sonst keiner zusätzlichen mechanischen Beanspruchung ausgesetzt sind. Die Arbeitslage ist eine zweite räumliche Lage der Längsachse der Nadel, die auch als Zustelllage oder Klemmlage bezeichnet werden kann. Eine Überführung der Längsachse, und damit natürlich auch der Nadel, aus der Ausgangslage in die Arbeitslage und zurück kann durch ein Verkippen oder ein Verschieben der Längsachse oder durch eine Kombination aus Verkippen und Verschieben der Längsachse in mindestens einer Ebene oder im Raum bewirkt sein. Die Nadelspitze befindet sich in der Ausgangslage in einer ersten Position und in der Arbeitslage in einer lateralen Position. Die erste Position und die laterale Position können mit einer Strecke von bis zu 2 mm, vorzugsweise bis zu 1,5 mm, voneinander beabstandet sein. Durch die taumelnde Lagerung der Nadeln ist somit eine individuelle Korrektur jeder einzelnen Nadelspitze in einem Kreisdurchmesser von bis zu 4 mm ermöglicht.

Das Führungsmittel kann mehrere Führungselemente umfassen, von denen jedes in einen Durchbruch einsteckbar ist. Die Anzahl der Führungselemente ist vorzugsweise nicht größer als die Anzahl der Durchbrüche. Die Führungselemente sind dabei vorzugsweise so gestaltet, dass diese formschlüssig in die Durchbrüche einsteckbar sind. Dabei sind die Führungselemente vorteilhafterweise untermaßig gestaltet, um ein unerwünschtes Verklemmen des Führungsmittels zu vermeiden.

Um eine Ausrichtung des Adapters bei gleichzeitig möglicher Ausrichtung der einzelnen Nadeln zu den jeweils zu kontaktierenden Testpunkten zu unterstützen, ist das Führungsmittel vorzugsweise von den Nadeln mechanisch weitgehend entkoppelt. So kann das Führungsmittel am Adapter eingespannt sein, während die Nadeln schwimmend gelagert sind.

Die Durchbrüche und das Führungsmittel bilden in ihrem Zusammenwirken eine Vorrichtung zur (Grund-)Ausrichtung des Adapters bezüglich des spiegelsymmetrischen Musters der Testpunkte.

Das Führungsmittel ragt vorzugsweise in einer Zustellrichtung, in der der Adapter den Testpunkten zustellbar ist, über die Nadelspitzen hinaus. In weiteren Ausführungen des Adapters können die Führungsmittel in Zustellrichtung auch auf gleicher Höhe oder unterhalb der Nadelspitzen enden. Ein spiegelsymmetrisches Muster der Nadelspitzen entspricht der Anzahl und Anordnung von parallel zueinander angeordneten Nadeln. Sind die Nadeln nicht parallel zueinander angeordnet, ist das spiegelsymmetrische Muster durch die Nadelspitzen gebildet.

Das Muster kann mehrere Symmetrieachsen aufweisen. Die Testpunkte können jede für eine elektrische Kontaktierung geeignete Ausgestaltung aufweisen und beispielsweise Lötaugen, auf oder in der Leiterplatte befindliche Kontaktbereiche, Testpunkte, Durchkontaktierungen, Bauteilpins oder Bereiche elektrischer Leitungsbahnen sein. Die einzelnen Testpunkte können voneinander verschieden ausgeführt sein.

Es ist vorteilhaft, wenn die Durchbrüche bezüglich des Musters so angeordnet sind, dass bei einer Kontaktierung der Leiterplatte durch die Nadeln des Adapters von einer ihrer Seitenflächen her zwangsläufig Nadelspitzen anderer Nadeln mit den elektrisch kurzgeschlossenen Testpunkten in Kontakt gelangen, als bei einer Kontaktierung der Leiterplatte von ihrer jeweils anderen Seitenfläche. Dies wird vorzugsweise dadurch erreicht, dass mindestens einer der Durchbrüche bezüglich mindestens einer in dem Muster gewählten Symmetrieachse asymmetrisch angeordnet ist.

Sind mehrere Durchbrüche in der Leiterplatte vorhanden, kann jeder einzelne Durchbruch eine Symmetrieachse (Symmetrieachse des Durchbruchs) aufweisen. Die Symmetrieachse der Durchbrüche können zusammenfallen. Einzelne oder alle Symmetrieachsen der Durchbrüche können in weiteren Ausgestaltungen der erfindungsgemäßen Kontaktierungsanordnung mit der Symmetrieachse des spiegelsymmetrischen Musters der Testpunkte (Symmetrieachse des Musters) zusammenfallen.

In einer bevorzugten Ausführung ist das Muster aus elf Testpunkten gebildet. Diese elf Testpunkte können beispielsweise zur Einleitung der fünf Testbusse eines Boundary-Scan-Tests, eines oder mehrerer Massekontakte, der Spannungsversorgung sowie von Sondersignalen vorgesehen sein.

Die elektrisch kurzgeschlossenen Testpunkte sind vorzugsweise nicht symmetrisch zu einer Symmetrieachse des Durchbruchsche oder der Symmetrieachse mehrerer Durchbrücheangeordnet. Dadurch ist gewährleistet, dass die Testpunkte beim Einstecken des Adapters von verschiedenen Seitenflächen der Leiterplatte her durch unterschiedliche Nadelspitzen kontaktiert sind. In einer bevorzugten Ausführung ist ein ausgewählter Testpunkt mit einem Massekontakt elektrisch kurzgeschlossen. Dadurch ist es möglich, ohne eine zugeschaltete Spannungsversorgung, über den Kurzschluss eine Potentialerkennung durchzuführen und so eine Verdrehung, z. B. um 180° bei Kontaktierung von unterschiedlichen Seitenflächen der Leiterplatte her, zu detektieren (Verdrehungserkennung). Die elektrisch kurzgeschlossenen Testpunkte dienen einer Detektion der relativen Lagen der spiegelsymmetrischen Muster der Testpunkte und des spiegelsymmetrischen Musters der Nadelspitzen zueinander.

Es ist vorteilhaft, wenn die Testpunkte solche Abmaße und Abstände zueinander aufweisen, dass Nadeln eines verbreiteten Standards, z. B. 100 mil (1/10 inch = 2,54 mm), verwendbar sind. Nadeln dieses Standards sind vergleichsweise preiswert, gut verfügbar, wartungsarm und robust.

Eine entsprechend der detektierten relativen Lage erforderliche Beschaltung der Nadeln erfolgt vorzugsweise über eine Beschaltungssteuerung.

In einer weiteren vorteilhaften Ausführung der erfindungsgemäßen Kontaktierungsanordnung weist der Adapter ein Gehäuse, in dem die Nadeln angeordnet sind, und einen Adapterfuß auf. In dem Adapterfuß ist das Gehäuse beweglich angeordnet. Bevorzugt ist es, wenn das Gehäuse bezüglich wenigstens einer Ebene allseitig lateral um einen bestimmten Betrag beweglich ist. Beispielsweise kann das Gehäuse mittels Federn im Adapterfuß gehalten sein, so dass das Gehäuse lateral beweglich ist und nach einer lateralen Bewegung, z. B. nach einem erfolgten Test, wieder in eine Ruheposition zurückgestellt ist. Es ist eine günstige Ausführung, wenn das Gehäuse reibungsarm gelagert ist, so dass eine Rückstellung des Gehäuses in die Ruheposition schnell, vollständig und mit wenigen Reibungsverlusten erfolgt. Beispielsweise kann das Gehäuse auf einem Schmiermittelfilm oder auf einer Oberfläche eines Materials mit einem geringen Reibungskoeffizienten, wie Polytetrafluorethylen (PTFE), geführt sein. Eine Austauschbarkeit des Gehäuses ist bevorzugt, um auf unterschiedliche Testsituationen, z. B. verschiedene anzuwendende Testverfahren, verschieden gestaltete oder verschieden dimensionierte Muster, durch Wechsel des Gehäuses reagieren zu können oder Wartungsarbeiten, Reparaturen und Verschleißkontrollen durchführen zu können. Es ist auch möglich, dass der Adapter entsprechend austauschbar ist. Vorzugsweise ist das Gehäuse allseitig lateral zu einer Zustellrichtung beweglich angeordnet. So kann die Zustellrichtung entlang einer Achse verlaufen, während das Gehäuse senkrecht zu dieser Zustellrichtung allseitig lateral um einen bestimmten Betrag beweglich gelagert ist. Die Zustellrichtung kann die Richtung sein, in welcher der Adapter der Leiterplatte zum Zwecke der Kontaktierung der Testpunkte zuzustellen ist.

Der Adapter kann manuell einsteckbar sein. Für eine Implementierung des Tests z. B. in einer Produktionslinie ist es günstig, wenn der Adapter mit einer Zustelleinrichtung verbunden ist, durch die der Adapter in der Zustellrichtung den Testpunkten zustellbar ist. Eine solche Zustelleinrichtung kann beispielsweise ein Roboterarm oder eine Hubvorrichtung sein.

Jede der Nadeln ist lateral zu ihrer Längsachse taumelnd beweglich (Taumelspiel) gelagert. Durch konstruktive Maßnahmen wie eine übermaßige Ausführung des Durchmessers einer Führung, in der die Nadel geführt ist sowie durch eine laterale Auslenkbarkeit einer Lagerung der Nadel (z. B. eine in Richtung der Längsachse der Nadel angeordnete, lateral biegbare Spiralfeder), ist eine laterale Beweglichkeit der Nadel um einen bestimmten, d.h. bekannten, Betrag ermöglicht. Das kann durch eine schwimmende Befestigung, beispielsweise mittels Federn, oder durch eine elektrische Fixierung, beispielsweise mittels eines oder mehrerer Magneten, jeder einzelnen Nadeln erreicht sein. Es ist auch vorteilhaft, wenn die Nadeln entlang ihrer jeweiligen Längsachsen beweglich sind. So können die Nadeln über axial angeordnete Federn mit dem Gehäuse verbunden, axial federnd gelagert, sein. Eine Führung kann eine Öffnung in einer Wand eines Gehäuses des Adapters sein, durch welche die Nadel hindurchragt. Ist der freie Durchmesser (z. B. bei einer kreisförmigen Öffnung) oder die geringste lichte Weite (z. B. bei einer ovalen oder eckigen Öffnung) größer als der Durchmesser der Nadel im Bereich der Öffnung, ist eine laterale Beweglichkeit einer nicht eingespannten Nadel ermöglicht.

Eine Klemmung des eingesteckten Adapters an der Leiterplatte ist dadurch erreichbar, dass Mittel zur lateralen Bewegung der Nadeln vorhanden sind, durch die mindestens eine Nadel in einer bestimmten Richtung und um einen bestimmten Betrag aus einer Ausgangslage in eine Arbeitslage (und zurück) auslenkbar ist und in der Arbeitslage gehalten werden kann. Solch ein Mittel kann beispielsweise ein Konus sein, der vom Adapter her in Zustellrichtung zwischen die Nadeln bewegt ist und der so gestaltet und dimensioniert ist, dass die Längsachse der Nadeln radial einwärts ausgelenkt sind. Eine entgegengesetzte, die Längsachse der Nadeln nach auswärts auslenkende, Wirkung ist beispielsweise durch einen um die Nadeln greifenden, kontrahierbaren Ring oder durch die Verwendung eines entgegen der Zustellrichtung bewegten Konus erzielbar.

Durch Wirkung des Mittels zur lateralen Bewegung der Nadeln ist die Längsachse mindestens einer Nadel aus einer ersten räumlichen Lage, der Ausgangslage, in einer bestimmten Richtung und um einen bestimmten Betrag in eine zweite räumliche Lage, die Arbeitslage, durch ein Verkippen, ein Verschieben oder durch eine Kombination von Verkippen und Verschieben, auslenkbar. Die Nadel ist durch Wirkung des Mittels zur lateralen Bewegung der Nadel in der zweiten räumlichen Lage gehalten.

In weiteren Ausführungen des erfindungsgemäßen Adapters können durch das Mittel zur lateralen Bewegung der Nadeln simultan oder sequenziell nacheinander mehrere Nadeln oder alle Nadeln auslenkbar sein.

Ein zur Kontaktierung der Testpunkte dienender Endbereich der Nadel, z. B. die Nadelspitze, kann als Kontaktkopf ausgebildet sein. Neben den aus dem Stand der Technik bekannten spitzen oder leicht abgerundeten Ausführungen ist es möglich, dass der Kontaktkopf mindestens über Abschnitte des Endbereiches gegenüber einem Schaftabschnitt der Nadel verdickt ist. Durch eine solche Gestaltung der Kontaktköpfe ist ein verbesserter Toleranzausgleich sowie eine Unterstützung einer Klemmung des Adapters auf der Leiterplatte erreicht. Durch eine Klemmung wird eine druckfreie Adaptierung ermöglicht und ein Durchbiegen der Leiterplatte bei der Adaptierung vermieden. Die Adaptierung kann stressfrei erfolgen. Ist der Kontaktkopf die Nadelspitze, entspricht das spiegelsymmetrische Muster der Nadelspitzen einem spiegelsymmetrischen Muster der Kontaktköpfe.

Ein zur Kontaktierung der Testpunkte dienender Endbereich kann in weiteren Ausführungen vor der Nadelspitze angeordnet sein und von der Nadelspitze überragt werden. In einer solchen Ausführung ist der Begriff des spiegelsymmetrischen Musters der Nadelspitzen in seiner Funktion entsprechend als durch das spiegelsymmetrische Muster der Kontaktköpfe realisiert anzusehen.

Die erfindungsgemäße Kontaktierungsanordnung ermöglicht eine Kontaktierung von Testpunkten einer Leiterplatte von beiden Seitenflächen der Leiterplatte her, wobei detektierbar ist, von welcher der Seitenflächen her kontaktiert wird. Diese Information ist unmittelbar nach dem Einstecken des Adapters in die Leiterplatte mittels einer Potentialerkennung zweier kurzgeschlossener Testpunkte ermittelbar. Die Kontaktierungsanordnung ist auch in Testgeräten und Testsystemen nutzbar, in denen bisher keine Kontaktierung mittels Nadeln eingesetzt wurde. Durch die Möglichkeit einer Klemmung ist eine druckfreie Adaptierung der Leiterplatte durch den Adapter ermöglicht, wodurch vorteilhaft Stresseinwirkungen auf die Leiterplatte vermieden werden.

Die Aufgabe wird ferner durch einen Adapter zur elektrischen Kontaktierung einer Anzahl von in einem spiegelsymmetrischen Muster auf einer Leiterplatte, die mindestens einen Durchbruch aufweist, angeordneten Testpunkten, gelöst. Der Adapter weist zudem ein Führungsmittel und Nadeln mit Nadelspitzen auf. Das Führungsmittel ist in mindestens einen Durchbruch der Leiterplatte einsteckbar. Bei vollständig eingestecktem Führungsmittel steht jede der Nadelspitzen mit genau einem Testpunkt in Verbindung. Außerdem ist jede Nadel lateral zu ihrer Längsachse taumelnd gelagert. Durch eine taumelnde Lagerung ist eine laterale Beweglichkeit zwischen einer Ausgangslage und einer Arbeitslage der Längsachse der Nadel ermöglicht.
Die erfindungsgemäße Kontaktierungsanordnung und der erfindungsgemäße Adapter wird nachfolgend anhand von Ausführungsbeispielen und Abbildungen näher erläutert. Es zeigen die Abbildungen:
Fig. 1 ein erstes Ausführungsbeispiel eines erfindungsgemäßen Adapters im Längsschnitt mit zwei Nadeln,
Fig. 2 ein Muster von Testpunkten einer erfindungsgemäßen Kontaktierungsanordnung,
Fig. 3 ein zweites Ausführungsbeispiel eines erfindungsgemäßen Adapters im Längsschnitt mit einem Mittel zur lateralen Bewegung der Nadeln in Form eines Konus,
Fig. 4 ein drittes Ausführungsbeispiel eines erfindungsgemäßen Adapters im Längsschnitt mit einem Mittel zur lateralen Bewegung der Nadeln in Form eines kontrahierbaren Ringes,
Fig. 5 ein viertes Ausführungsbeispiel eines erfindungsgemäßen Adapters im Längsschnitt in einer Halterung und
Fig. 6 eine Zustellvorrichtung zur Zustellung des Adapters zu Testpunkten.

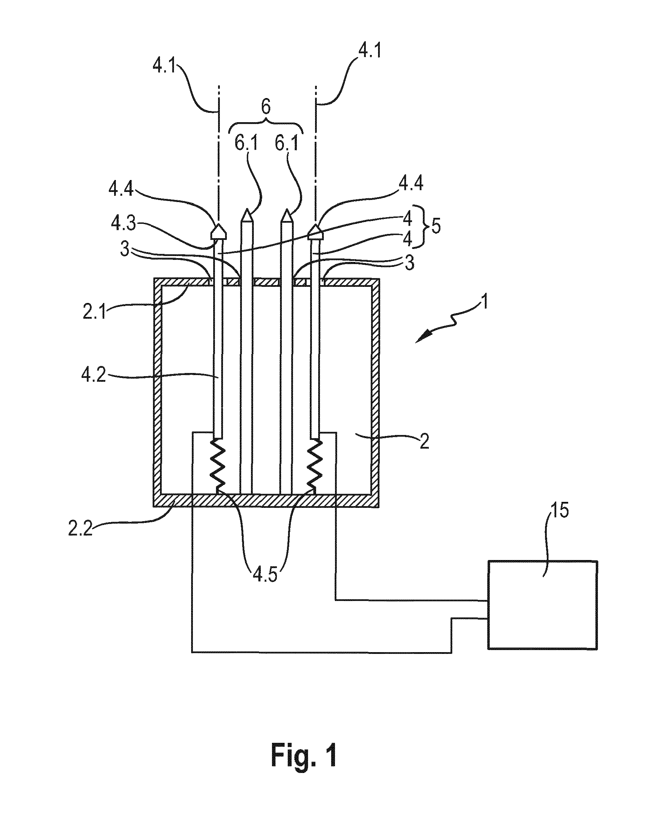

Ein in Fig. 1 gezeigter erfindungsgemäßer Adapter 1 weist als wesentlich Teile ein Gehäuse 2 mit einer Vorderwand 2.1 und einer Rückwand 2.2 auf, in dem elf Nadeln 4 (der Übersicht halber schematisch nur zwei gezeigt) mit zueinander parallel verlaufenden Längsachsen 4.1, die durch je eine Führungsöffnung 3 in der Vorderwand 2.1 des Gehäuses 2 aus dem Gehäuse 2 ragen und zwei Positionierstifte als Führungselemente 6.1 eines Führungsmittel 6, die ebenfalls durch die Vorderwand 2.1 ragen.

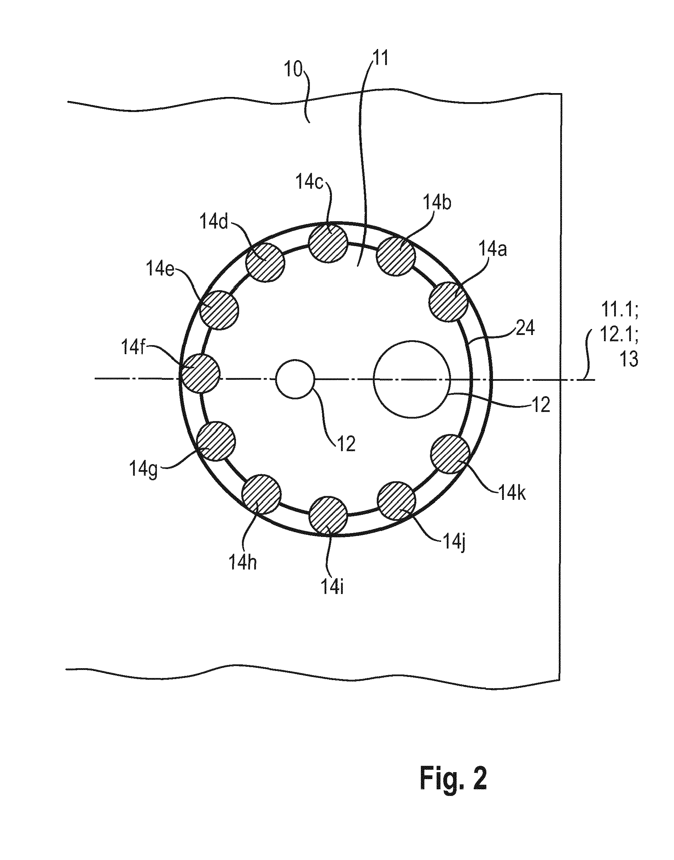

Die Nadeln 4 sind jeweils mittels einer Feder 4.5 mit der Rückwand 2.2 des Gehäuses 2 verbunden und dadurch axial federnd gelagert. Die Nadeln 4 sind in einem Schaftbereich 4.2 durch die Führungsöffnungen 3 mit Spiel (Taumelspiel) geführt, so dass die Nadeln 4 lateral um einen bestimmten Betrag beweglich sind. Ein zur Kontaktierung dienender freier Endbereich 4.3 der Nadeln 4 ist jeweils als Kontaktkopf 4.4 in Form eines in einer Kegelspitze auslaufenden Zylinderabschnitts ausgebildet, wobei der Kontaktkopf 4.4 einen größeren Durchmesser aufweist als ein Schaftbereich 4.2 der Nadel 4, die der Norm 100 mil (2,54 mm) entspricht. Durch die Anzahl und räumlichen Anordnung der Nadeln 4 ist ein spiegelsymmetrisches Muster der Nadelspitzen 5 gebildet (siehe Fig. 2), dass eine Symmetrieachse des spiegelsymmetrischen Musters der Nadelspitzen 13 besitzt.

In weiteren Ausführungen der Kontaktierungsanordnung können auch Nadeln 4 mit anderen Dimensionierungen und anderen Abständen und Anordnungen zueinander zum Einsatz kommen.

Die Führungselemente 6.1 weisen einen Durchmesser von 3 mm auf und sind an der Rückwand 2.2 mittels einer Einspannung befestigt und durch Führungsöffnungen 3 durch die Vorderwand 2.1 geführt. Die freien Enden der Führungselemente 6.1 ragen über die Kontaktköpfe 4.4 hinaus. Die Nadeln 4 sind jeweils signaltechnisch mit einer Beschaltungssteuerung 15 verbunden, durch die eine Beschaltung der Nadeln 4 in Abhängigkeit der detektierten relativen Lage des Adapters 1 und einer Leiterplatte 10 (siehe Fig. 2) erfolgt.

Die Vorderwand 2.1 kann in weiteren Ausführungen des Adapters 1 als nicht mit dem Gehäuse 2 verbundene Platte gestaltet sein. Die Führungsöffnungen 3, durch welche die Führungselemente 6.1 ragen, sind so groß ausgestaltet, dass die Vorderwand 2.1 bezüglich der Führungselemente 6.1 lateral um einen bestimmten Betrag beweglich ist.

Ein auf einer Leiterplatte 10 angeordnetes und aus elf Testpunkten 14a bis 14k gebildetes spiegelsymmetrisches Muster der Testpunkte 11 ist in Fig. 2 dargestellt. In dem spiegelsymmetrischen Muster der Testpunkte 11 sind zwei kreisrunde Durchbrüche 12 mit voneinander verschiedenen Durchmessern in der Leiterplatte 10 vorhanden. Die Anordnung der Durchbrüche 12 ist bezüglich einer Symmetrieachse des spiegelsymmetrischen Musters der Testpunkte 11.1 spiegelsymmetrisch und fällt mit und der Symmetrieachse des spiegelsymmetrischen Musters der Nadelspitzen 13 zusammen, wenn der Adapter 1 mit seinen Führungselementen 6.1 in die Durchbrüche 12 eingesteckt ist. Die Testpunkte 14a bis 14k sind auf einer Kreisbahn 24 angeordnet, deren Mittelpunkt gemeinsam mit den Mittelpunkten der Durchbrüche 12 auf einer gemeinsamen Linie liegt. Die Durchbrüche 12 weisen jeweils Symmetrieachsen des Durchbruchs 12.1 auf, bezüglich der die Querschnitte der Durchbrüche 12 jeweils spiegelsymmetrisch sind. Auch die beiden Symmetrieachsen des Durchbruchs 12.1 fallen mit den vorgenannten Symmetrieachsen 11.1 und 13 zusammen. In Bezug auf jede andere durch den Mittelpunkt der Kreisbahn 24 verlaufende Achse (nicht gezeigt) sind die Durchbrüche 12 asymmetrisch angeordnet.

Bezüglich der zusammenfallenden Symmetrieachsen 11.1, 12.1 und 13 ist auch das spiegelsymmetrische Muster der Testpunkte 11 symmetrisch. Die Testpunkte 14a bis 14k sind auf der Leiterplatte 10 aufgebrachte Kontaktflächen (pads) mit einem Durchmesser von 1 mm Die Mittelpunkte der Testpunkte 14a bis 14k sind voneinander mindestens je 2,54 mm beabstandet.

Die Testpunkte 14a und 14f sind miteinander elektrisch kurzgeschlossen und dienen im Zustand der Kontaktierung des Musters 11 durch die Kontaktköpfe 4.4 einer Detektion der relativen Lage von Leiterplatte 10 und Adapter 1. Die Testpunkte 14b und 14 j sind für wählbare Sondersignale vorgesehen, während der Testpunk 14i ein elektrischer Massepunkt (Erdung) ist. Testpunkt 14c dient der Spannungsversorgung zur Durchführung von Tests wie dem Boundary-Scan-Test. Zur Durchführung dieses Test dienen die Testpunkte 14d, 14e, 14g, 14h und 14k mit den Funktionen Test-Reset-Eingang (TMS), Test-Takt (TCK), Test-Mode-Selection (TMS), Testdatenausgang (TDO) beziehungsweise Testdateneingang (TDI) als TAP (Test Access Port).

In weiteren Ausführungen können die Testpunkte 14a bis 14k anders gestaltet, dimensioniert und angeordnet sein. Die Durchbrüche 12 können andere Anzahlen, Formen und/oder Anordnungen aufweisen.

Die Fig. 2 entspricht außerdem schematisch einer Draufsicht auf die Vorderwand 2.1 eines zur Kontaktierung der Testpunkte 14a bis 14k vorgesehenen Adapters 1, wobei die als Testpunkte 14a bis 14k bezeichneten kleineren Punkte die Kontaktköpfe 4.4 und die als Durchbrüche 12 bezeichneten größeren Punkte die Führungsmittel 6 wären. Die in Fig. 2 gezeigte Symmetrieachse entspricht hier der Symmetrieachse des spiegelsymmetrischen Musters der Nadelspitzen 13. Durch die bezüglich der Symmetrieachse 13 spiegelssymmetrische Anordnung der Kontaktköpfe 4.4 ist ein spiegelsymmetrisches Muster der Nadelspitzen 5 gebildet.

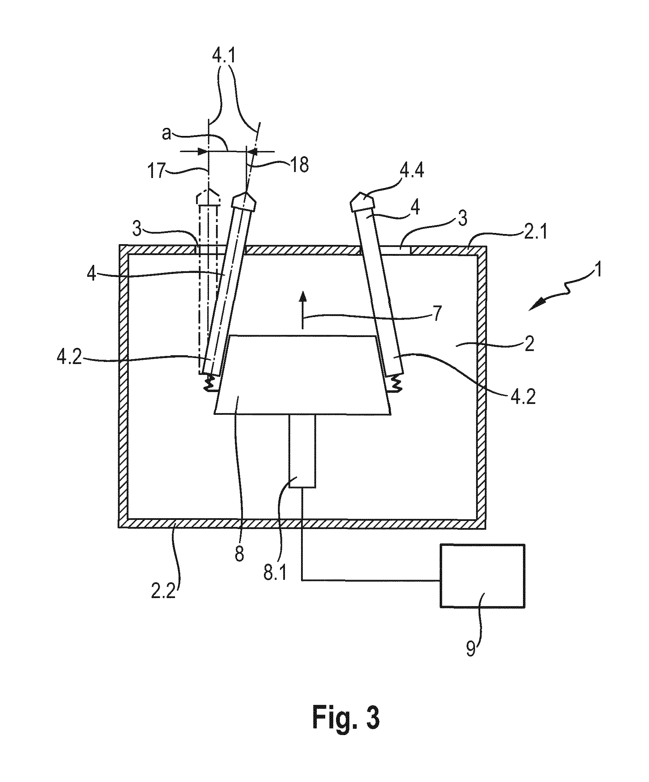

In einem zweiten Ausführungsbeispiel des Adapters 1 der erfindungsgemäßen Kontaktierungsanordnung gemäß Fig. 3 ist in dem Gehäuse 2 ein Mittel zur lateralen Bewegung der Nadeln 8 in Form eines Konus vorhanden. Der Konus ist in und entgegen einer Zustellrichtung 7 mittels eines Antriebs 8.1, der mit einer Steuerung 9 in Verbindung steht, gesteuert beweglich. Wird der Konus in Zustellrichtung 7 bewegt, tritt dieser über seine konischen Außenflächen mit den hinteren Schaftbereichen 4.2 der Nadeln 4 in Berührung. Bei weiter erfolgender Bewegung des Konus in Zustellrichtung 7 werden die Nadeln 4 an ihren hinteren Schaftbereichen 4.2 in Bezug auf die Zustellrichtung 7 radial nach außen gedrängt. Da die Nadeln 4 in den Führungsöffnungen 3 geführt sind, werden die Längsachsen 4.1 der Nadeln 4 gekippt, so dass die Kontaktköpfe 4.4 in Bezug auf die Zustellrichtung 7 radial nach innen ausgelenkt und aus einer Ausgangslage 17 (durch eine gestrichelte Nadel 4 verdeutlicht) um einen Betrag einer Auslenkungsstrecke a in eine laterale Position als eine Arbeitslage 18 ausgelenkt werden (nur für die links dargestellte Nadel 4 gezeigt). Es wird zwar die Nadel 4 ausgelenkt, zur Beschreibung der Ausgangslage 17 und der Arbeitslage 18 wird aber der Kontaktkopf 4.4 der jeweiligen Nadel 4 als Bezug gewählt. Ein Drehpunkt, um den sich die Nadeln 4 bei ihrer Auslenkung drehen, befindet sich im Bereich der jeweiligen Führungsöffnung 3. Genauer gesagt, sind die Nadeln 4 an den die Führungsöffnung 3 umgrenzenden Bereiche der Vorderwand 2.1 (Kanten) angelehnt und über diese Kanten gekippt. Der jeweilige maximale Betrag der Auslenkstrecke a ist durch die Größe der jeweiligen Führungsöffnung 3 und die Länge der Nadel 4 außerhalb des Gehäuses 2 bestimmt. Sind die Nadeln 4 in als Lötaugen ausgebildete Testpunkte 14a bis 14k eingesteckt, ist durch die in Arbeitslage 18 befindlichen Nadeln 4 eine Klemmung des Adapters 1 auf einer Leiterplatte 10 bewirkt. Das Führungselement 6 (nicht gezeigt), ist an der Rückwand 2.2 eingespannt. In diesem Ausführungsbeispiel sind die Nadeln 4 über Federn 4.5 axial federnd gelagert, wobei die Federn 4.5 an einer Seitenwand (nicht gezeigt) des Gehäuses 2 befestigt sind.

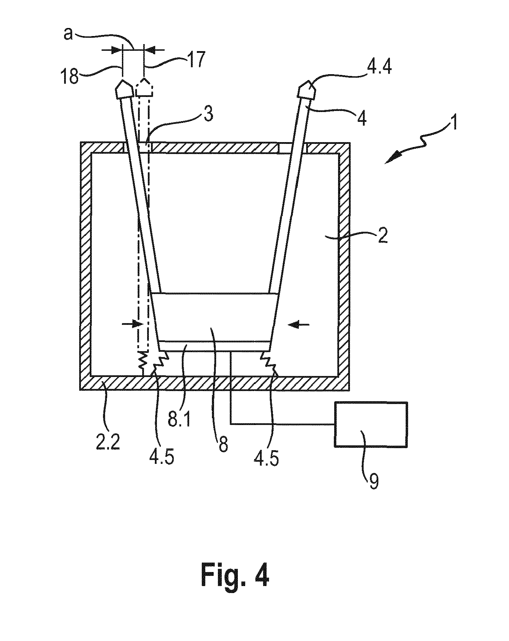

Eine weitere Möglichkeit zur Erzielung einer Klemmung ist in einer dritten Ausführung eines Adapters 1 in Fig. 4 gezeigt. Hier ist das Mittel zur lateralen Bewegung der Nadeln 8 ein um die in dem Gehäuse 2 befindlichen Enden der Nadeln 4 greifender, kontrahierbarer Ring, der mittels eines mit der Steuerung 9 verbundenen Antriebs 8.1 gesteuert kontrahierbar (spannbar) bzw. entspannbar ist. Bei einer Kontraktion des Mittel zur lateralen Bewegung der Nadeln 8 werden die Nadeln 4 in den Führungsöffnungen 3 radial nach außen gekippt. Die Kontaktköpfe 4.4 werden um einen Betrag einer Auslenkungsstrecke a aus der Ausgangslage 17 in die radial weiter außen befindliche Arbeitslage 18 bewegt. Die Nadeln 4 sind, über Federn 4.5 mit der Rückwand 2.2 verbunden, axial federnd gelagert.

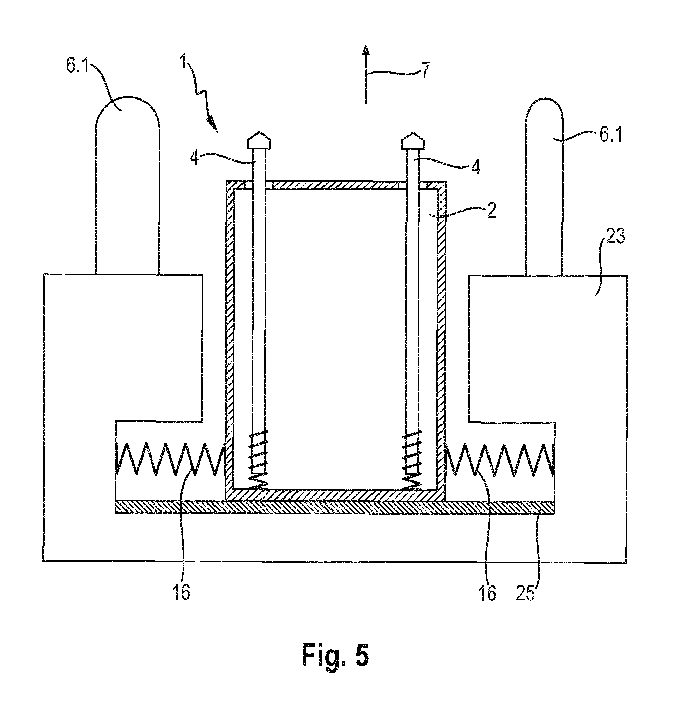

Der Adapter 1 weist in einem vierten Ausführungsbeispiel gemäß Fig. 5 einen Adapterfuß 23 auf, in dem das Gehäuse 2 eingestellt und mittels vier an dem Gehäuse 2 lateral angreifender und um 90° zueinander versetzt angeordneter Federn 16 (nur zwei gezeigt) gehalten ist. Zwischen dem Gehäuse 2 und dem Adapterfuß 23 ist eine Gleitmatte 25 aus PTFE angeordnet. Die Führungselemente 6.1 sind an dem Adapterfuß 23 angeordnet und dadurch, im Rahmen eines Betrages, um den das Gehäuse 2 lateral beweglich ist, weitgehend von dem Gehäuse 2 mechanisch entkoppelt. Der Adapterfuß 23 ist so gestaltet, dass das Gehäuse 2 auf der Gleitmatte 25 lateral zur Zustellrichtung 7 beweglich ist. Die Federn 16 sind so eingestellt, dass das Gehäuse 2 in einem Ruhezustand in der Mitte des Adapterfußes 23 gehalten ist. In Anschluss an eine laterale Bewegung und nach Aufhebung einer die laterale Bewegung verursachenden Kraft, wird das Gehäuse 2 durch die Federn 16, die infolge der Bewegung gestreckt bzw. gestaucht waren, wieder in die Ausgangslage 17 (nicht gezeigt) zurück gestellt. Diese Ausführung erlaubt eine laterale Beweglichkeit des Gehäuses 2 sowie eine unabhängige, taumelnde und außerdem eine axiale Bewegung jeder einzelnen Nadel 4. Dadurch ist ein hohes Maß an Ausgleichsmöglichkeiten von Toleranzen (bis 1,5 mm) zu kontaktierender Testpunkte geschaffen.

Statt der Federn 16 kann in weiteren Ausführungen auch ein elastisches Material, z. B. ein Schaumstoff, zum Einsatz kommen.

Der Adapterfuß 23 kann in weiteren Ausführungen so gestaltet sein, dass das Gehäuse 2 in Zustellrichtung 7 axial so gelagert ist, dass es nicht aus dem Adapterfuß 23 herausfallen kann. Dadurch wird eine Überkopf-Verwendung des Adapters 1 ermöglicht. Die Federn 16 können in weiteren Ausführungen des Adapterfußes 23 auch durch aktive Mittel wie ansteuerbare Stellvorrichtungen ersetzt sein.

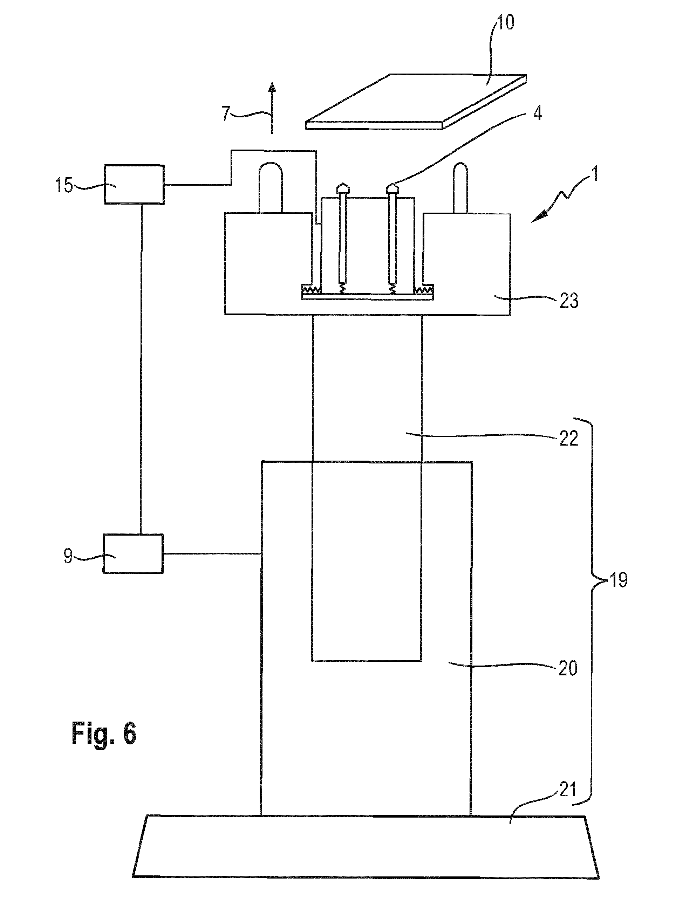

Der in Fig. 5 gezeigte Adapter 1 mit Adapterfuß 23 kann in einer in Fig. 6 vereinfacht gezeigten Zustelleinrichtung 19 angeordnet sein, die als wesentliche Elemente einen Gerätefuß 21, einen Antrieb 20 und ein Hubelement 22 umfasst. Der Gerätefuß 21 ist an seiner Unterseite magnetisch, so dass er auf einem entsprechenden Untergrund leicht positionierbar und wieder entfernbar ist. In weiteren Ausführungen der Zustelleinrichtung 19 kann der Gerätefuß 21 auch anders befestigt, beispielsweise geklemmt, durch Unterdruck gehalten oder geschraubt, sein. Die Zustelleinrichtung 19 kann auch ohne eine Vorrichtung zur Befestigung gestaltet sein. Der Antrieb 20 nimmt einen Stempel als Hubelement 22 auf, welches durch den Antrieb 20 in und entgegen der Zustellrichtung 7 verfahrbar ist. Der mögliche Zustellweg beträgt 30 mm, wodurch eine Bauteilfreiheit auf einer zu kontaktierenden Leiterplatte 10 von 20 mm gewährleistet ist. An dem Hubelement 22 befindet sich der Adapter 1. Der Antrieb 20 ist mit der Steuerung 9 verbunden, während die Nadeln 4 mit der Beschaltungssteuerung 15 verbunden sind (vereinfacht gezeigt). Beschaltungssteuerung 15 und Steuerung 9 sind signaltechnisch miteinander verbunden. In weiteren Ausführungen der Zustelleinrichtung 19 kann die Beschaltungssteuerung 15 in die Steuerung 9 integriert sein.

Die Verwendung der erfindungsgemäßen Kontaktierungsanordnung wird anhand der Fig. 2 und 6 beschrieben. Eine zur Durchführung eines Boundary-Scan-Tests zu kontaktierende Leiterplatte 10 wird so positioniert, dass der Adapter 1 den Testpunkten 14a bis 14k zustellbar ist. Das spiegelsymmetrische Muster der Nadelspitzen 5 ist durch die Anordnung der Kontaktköpfe 4.4 in einem spiegelsymmetrischen Muster (siehe Fig. 1) gegeben und ist in Form und Dimension entsprechend passend zu dem von den Testpunkten 14a bis 14k gebildeten spiegelsymmetrischen Muster der Testpunkte 11 ausgebildet. Durch die Steuerung 9 wird der Antrieb 20 der Zustelleinrichtung 19 angesteuert und das Hubelement 22 mit dem Adapter 1 in Zustellrichtung 7 den Testpunkten 14a bis 14k zugestellt. Nachdem mindestens eines der Führungselemente 6.1 in einen Durchbruch 12 so eingesteckt ist, dass die Nadeln 4 noch nicht in Kontakt mit den Testpunkten 14a bis 14k und/oder mit der Oberfläche der Leiterplatte 10 gelangen, wird der Adapter 1 ausgerichtet, indem das zweite Führungselement 6.1 des Führungsmittels 6 in den zweiten Durchbruch 12 gelangt. Dies kann durch leichte Bewegungen des Adapters 1 und/oder mindestens eines der Elemente der Zustelleinrichtung 19 bewirkt sein. Unterstützt wird die Ausrichtung des Adapters 1 durch die laterale Beweglichkeit des Gehäuses 2 infolge der Befestigung mittels der Federn 16 und dem Aufstehen des Gehäuses 2 auf der Gleitmatte 25. Nach erfolgter Ausrichtung des Adapters 1, wird der Adapter 1 weiter zugestellt, bis die Kontaktköpfe 4.4 jeweils einen der Testpunkte 14a bis 14k kontaktieren. Dabei kann jede Nadel 4 aufgrund ihres ermöglichten Taumelspiels auf die individuelle Toleranz und Beschaffenheit des jeweiligen Testpunkts 14a bis 14k reagieren, indem die jeweilige Nadel 4 passiv ausgerichtet wird. Der Adapter 1 wird den Testpunkten 14a bis 14k so weit zugestellt, bis die Nadeln 4 etwa 2 bis maximal 5 mm in den Adapter 1 zurückgeschoben sind. Dadurch wird auch bei auftretenden Störungen, wie z. B. Vibrationen, während des Tests eine sichere und ununterbrochene Kontaktierung gewährleistet. Anschließend wird über eine Potentialerkennung ermittelt, welche der Nadeln 4 die elektrisch kurzgeschlossenen Testpunkte 14a und 14f kontaktieren und so die relative Lage des Adapters 1 zur Leiterplatte 10 detektiert. Entsprechend des Ergebnisses der Detektion werden die Nadeln 4 durch die Beschaltungssteuerung 15 beschaltet und der Test durchgeführt. Nach erfolgtem Test wird der Adapter 1 wieder entfernt, indem durch die Beschaltungssteuerung 15 ein Signal an die Steuerung 9 geleitet wird und durch Ansteuerung des Antriebs 20 der Adapter 1 entgegen der Zustellrichtung 7 von der Leiterplatte 10 entfernt und die Kontaktierung aufgehoben wird. Nach der Entfernung des Adapters 1 wird das Gehäuse 2 durch die Federn 16 wieder in eine Ausgangslage 17 zurückgestellt.

Die erfindungsgemäße Kontaktierungsanordnung stellt eine universal anwendbare Möglichkeit dar, um insbesondere automatisch JTAG-Schnittstellen zur Durchführung von Tests, wie den Boundary-Scan-Test oder die JTAG-Emulation, zu adaptieren. Voraussetzung ist ein speziell gestaltetes spiegelsymmetrisches Muster von Testpunkten 11. Aufgrund einer automatischen Detektion der relativen Lage des Adapters 1 zur Leiterplatte 10 ist es bei Verwendung der erfindungsgemäßen Kontaktierungsanordnung unerheblich, von welcher Seitenfläche der Leiterplatte 10 her die Leiterplatte 10 kontaktiert ist.

### Bezugszeichenliste

| | |
|---|---|
| 1 | Adapter |
| 2 | Gehäuse |
| 2.1 | Vorderwand |
| 2.2 | Rückwand |
| 3 | Führungsöffnung |
| 4 | Nadel |
| 4.1 | Längsachse |
| 4.2 | Schaftbereich |
| 4.3 | Endbereich |
| 4.4 | Kontaktkopf |
| 4.5 | Feder (der Nadel 4) |
| 5 | spiegelsymmetrisches Muster der Nadelspitzen |
| 6 | Führungsmittel |
| 6.1 | Führungselement |
| 7 | Zustellrichtung |
| 8 | Mittel zur lateralen Bewegung der Nadeln |
| 8.1 | Antrieb |
| 9 | Steuerung |
| 10 | Leiterplatte |
| 11 | spiegelsymmetrisches Muster der Testpunkte |
| 11.1 | Symmetrieachse des spiegelsymmetrischen Musters der Testpunkte |
| 12 | Durchbruch |
| 12.1 | Symmetrieachse des Durchbruchs |
| 13 | Symmetrieachse des spiegelsymmetrischen Musters der Nadelspitzen |
| 14a bis 14k | Testpunkt |
| 15 | Beschaltungssteuerung |
| 16 | Feder (des Adapters 1) |
| 17 | Ausgangslage |
| 18 | Arbeitslage |
| 19 | Zustelleinrichtung |
| 20 | Antrieb (der Zustelleinrichtung 19) |
| 21 | Gerätefuß |
| 22 | Hubelement |
| 23 | Adapterfuß |
| 24 | Kreisbahn |
| 25 | Gleitmatte |
| a | Auslenkungsstrecke (des Kontaktkopfes 4.4) |

## Patentansprüche

1. Kontaktierungsanordnung zur elektrischen Kontaktierung einer Anzahl von Testpunkten (14a bis 14k) auf einer Leiterplatte (10), aufweisend
- die Leiterplatte (10) mit den Testpunkten (14a bis 14k), wobei die Testpunkte (14a bis 14k) auf der Leiterplatte (10) in einem spiegelsymmetrischen Muster (11) angeordnet sind und in der Leiterplatte (10) mindestens ein Durchbruch (12) vorhanden ist und zwei der Testpunkte (14a bis 14k) miteinander elektrisch kurzgeschlossen sind, und
- einen Adapter (1) zur Kontaktierung der Testpunkte (14a bis 14k) mit einem Führungsmittel (6) und Nadeln (4) mit Nadelspitzen, wobei
- das Führungsmittel (6) in die Durchbrüche (12) der Leiterplatte (10) einsteckbar ist,
- bei vollständig eingestecktem Führungsmittel (6) jede der Nadelspitzen mit genau einem Testpunkt (14a bis 14k) in Verbindung steht, und
- jede einzelne Nadel (4) lateral zu ihrer Längsachse (4.1) taumelnd gelagert ist.

2. Kontaktierungsanordnung nach Anspruch 1, **dadurch gekennzeichnet, dass** der mindestens eine Durchbruch (12) in der Leiterplatte (10) mindestens eine Symmetrieachse des Durchbruchs (12.1) aufweist und eine Symmetrieachse des spiegelsymmetrischen Musters der Testpunkte (11.1) mit der Symmetrieachse des Durchbruchs (12.1) zusammenfällt.

3. Kontaktierungsanordnung nach Anspruch 2, **dadurch gekennzeichnet, dass** der Durchbruch (12) in der Leiterplatte (10) einen von einer kreisrunden Form abweichenden und bezüglich einer Symmetrieachse des spiegelsymmetrischen Musters der Testpunkte (11.1) spiegelsymmetrischen Querschnitt aufweist.

4. Kontaktierungsanordnung nach einem der Ansprüche 1 bis 3, **dadurch gekennzeichnet, dass** das Führungsmittel (6) Führungselemente (6.1) umfasst, von denen jedes in einen Durchbruch (12) formschlüssig einsteckbar ist und die Anzahl der Führungselemente (6.1) nicht größer als die Anzahl der Durchbrüche (12) ist.

5. Kontaktierungsanordnung nach einem der vorhergehenden Ansprüche, **dadurch gekennzeichnet, dass** das spiegelsymmetrische Muster (11) aus elf Testpunkten (14a bis 14k) gebildet ist.

6. Kontaktierungsanordnung nach einem der vorhergehenden Ansprüche, **dadurch gekennzeichnet, dass** der Adapter (1) ein Gehäuse (2), in dem die Nadeln (4) angeordnet sind und einen Adapterfuß (23) aufweist, in dem das Gehäuse (2) allseitig lateral zu einer Zustellrichtung (7) beweglich angeordnet ist.

7. Kontaktierungsanordnung nach einem der Ansprüche 1 bis 6, **dadurch gekennzeichnet, dass** ein Mittel zur lateralen Bewegung der Nadeln (8) vorhanden ist, durch dessen Wirkung die Längsachse (4.1) mindestens einer Nadel (4) aus einer Ausgangslage (17) in einer bestimmten Richtung und um einen bestimmten Betrag (18) in eine Arbeitslage (18) auslenkbar ist und in der Arbeitslage (18) gehalten werden kann.

8. Kontaktierungsanordnung nach einem der vorhergehenden Ansprüche, **dadurch gekennzeichnet, dass** ein zur Kontaktierung der Testpunkte (14a bis 14k) dienender Endbereich (4.3) der Nadel (4) als Kontaktkopf (4.4) ausgebildet ist, der mindestens über Abschnitte des Endbereiches (4.3) gegenüber einem Schaftabschnitt (4.2) der Nadel (4) verdickt ist.

9. Kontaktierungsanordnung nach einem der vorhergehenden Ansprüche, **dadurch gekennzeichnet, dass** der Adapter (1) mit einer Zustelleinrichtung (19) verbunden ist, durch die der Adapter (1) in einer Zustellrichtung (7) den Testpunkten (14a bis 14k) zustellbar ist.

10. Adapter zur elektrischen Kontaktierung einer Anzahl von in einem spiegelsymmetrischen Muster (11) auf einer Leiterplatte (10), die mindestens einen Durchbruch (12) aufweist, angeordneten Testpunkten (14a bis 14k), wobei
- der Adapter (1) ein Führungsmittel (6) und Nadeln (4) mit Nadelspitzen aufweist, wobei
- das Führungsmittel (6) in die Durchbrüche (12) einsteckbar ist,
- bei vollständig eingestecktem Führungsmittel (6) jede der Nadelspitzen mit genau einem Testpunkt (14a bis 14k) in Verbindung steht, und
- jede einzelne Nadel (4) lateral zu ihrer Längsachse (4.1) taumelnd gelagert ist.
